# EUROPEAN PATENT APPLICATION

(11) **EP 2 639 980 A1**
(43) Date of publication of application: **18.09.2013**
(21) Application number: 13153345.7
(22) Date of filing: 30.01.2013
(51) Int. Cl.: H04H 60/41, H03J 1/00

(54) **Receiving apparatus and display method**

(30) Priority: 15.03.2012 JP 2012058227
(71) Applicant: Sony Corporation, Tokyo 108-0075 (JP)
(72) Inventor: Murahata, Katsuyuki, Minato-ku, Tokyo 108-0075 (JP)
(74) Representative: Jackson, Jonathan Andrew

(57) **Abstract**

A receiving apparatus includes: a determining portion configured to scan a reception band of a broadcasting wave, compare a quality of a received signal with a predetermined quality, and carry out a determination; and a control portion. The control portion is configured to display information corresponding to a first broadcasting station in a first display form, the quality of the received signal from the first broadcasting station being determined to be equal to or higher than the predetermined quality, and display information corresponding to a second broadcasting station in a second display form, the quality of the received signal from the second broadcasting station being determined to be lower than the predetermined quality, the second display form being different from the first display form.

## Description

The present disclosure relates to a receiving apparatus and a display method used in the same.

In a radio receiving apparatus for receiving a radio wave, normally, setting is carried out in such a way that a broadcasting station which is preset can be dialed. For example, a reception environment of an in-vehicle radio receiving apparatus is changed along with a movement of a vehicle. Thus, it could be that the radio broadcasting station from which the broadcasting wave can be received is changed in correspondence to a change in the reception environment.

Japanese Patent Laid-Open No. 2011-135306 describes a technique with which a strength of an electric field is checked in accordance with a manipulation for pressing a receivable station button, and as a result of the checking, a broadcasting stations in each of which the strength of the electric field is equal or larger than a threshold value are displayed as receivable broadcasting stations in the form of a list. With this technique, the broadcasting station which a user desires to select can be dialed from the broadcasting stations which are displayed in the form of the list. It is noted that any of the broadcasting stations in each of which the strength of the electric field is smaller than the threshold value, and thus the broadcasting wave from each of which cannot be received is deleted from the list and is not displayed.

When the vehicle is moved, the reception environment temporarily becomes worse, for example, in a tunnel, an underground parking lot, a mountain area or the like in some cases. When the strength of the electric field is checked in the situation in which the reception environment temporarily becomes worse, it is determined that it may be impossible to receive a part of or all of the broadcasting waves from the broadcasting stations. Thus, any of the broadcasting stations from which the broadcasting waves are determined to be unable to be received becomes non-display. There is caused a problem such that for the purpose of displaying the information corresponding to the broadcasting stations from which the broadcasting waves become able to be received after the reception environment has been recovered, the receivable station button needs to be pressed again. In addition thereto, there is also a problem such that it takes time to execute processing for checking the strength of the electric field of the received signal again, and thus it may be impossible to carry out a dialing manipulation using the list until completion of this checking processing.

The present disclosure has been made in order to solve the problems described above, and it is therefore desirable to provide a receiving apparatus with which a broadcasting station which a user desires to select can be immediately dialed even when a reception environment for broadcasting is changed, and a display method used in the receiving apparatus.

In order to attain the desire described above, according to an embodiment of the present disclosure, there is provided a receiving apparatus including:
a determining portion configured to scan a reception band of a broadcasting wave, compare a quality of a received signal with a predetermined quality, and carry out a determination; and
a control portion configured to
   display information corresponding to a first broadcasting station in a first display form, a quality of a received signal from the first broadcasting station being determined to be equal to or higher than the predetermined quality, and
   display information corresponding to a second broadcasting station in a second display form, a quality of a received signal from the second broadcasting station being determined to be lower than the predetermined quality, the second display form being different from the first display form.

According to another embodiment of the present disclosure, there is provided a display method including:
scanning a reception band of a broadcasting wave;
comparing a quality of a received signal received through the scanning with a predetermined quality, thereby carrying out a determination;
displaying information corresponding to a first broadcasting station in a first display form, a quality of a received signal from the first broadcasting station being determined to be equal to or higher than the predetermined quality; and
displaying information corresponding to a second broadcasting station in a second display form, a quality of a received signal from the second broadcasting station being determined to be lower than the predetermined quality, the second display form being different from the first display form.

As set forth hereinabove, according to the present disclosure, it is possible to immediately dial a broadcasting station which a user desires to select even when a reception environment for a broadcasting is changed.

Various respective aspects and features of the invention are defined in the appended claims. Combinations of features from the dependent claims may be combined with features of the independent claims as appropriate and not merely as explicitly set out in the claims.

Embodiments of the invention will now be described with reference to the accompanying drawings, throughout which like parts are referred to by like references, and in which:
FIG. 1 is a float chart showing an example of a flow of processing of a technique associated with the present disclosure;
FIG. 2 is a block diagram showing a configuration of a receiving apparatus according to a first embodiment of the present disclosure;
FIG. 3 is a view showing an example of a display list;
FIG. 4 is a flow chart showing an example of processing for determining a quality of a received signal;
FIG. 5 is a flow chart showing a flow of processing in a display method according to a second embodiment of the present disclosure;
FIG. 6 is a flow chart showing a flow of processing in the display method according to the second embodiment of the present disclosure;
FIGS. 7A and 7B are respectively a diagram explaining an example of a list, and a view explaining an example of a display list based on the list shown in FIG. 7A;
FIGS. 8A and 8B are respectively a diagram explaining another example of a list, and a view explaining another example of a display list based on the list shown in FIG. 8A;
FIGS. 9A and 9B are respectively a diagram explaining still another example of a list, and a view explaining still another example of a display list based on the list shown in FIG. 9A;
FIG. 10 is a flow chart showing a flow of processing in a display method according to a third embodiment of the present disclosure;
FIG. 11 is a flow chart showing a flow of processing in the display method according to the third embodiment of the present disclosure;
FIGS. 12A and 12B are respectively a diagram explaining an example of a list, and a view explaining an example of a display list based on the list shown in FIG. 12A;
FIGS. 13A and 13B are respectively a diagram explaining another example of a list, and a view explaining another example of a display list based on the list shown in FIG. 13A; and
FIGS. 14A and 14B are respectively a view explaining a normal display form, and a view explaining an example of display when a broadcasting station name is displayed in the form of a gray list.

Embodiments of the present disclosure will be described in detail hereinafter with reference to the accompanying drawings. It is noted that the description will be given below in accordance with the following order.
1. First Embodiment (Receiving Apparatus)
2. Second Embodiment (Display Method)
3. Third Embodiment (Display Method)
4. Modified Changes

It should be noted that the embodiments and the modified changes which will be described below are merely suitably concrete examples of the present disclosure, and thus the contents of the present disclosure are not intended to be limited to the embodiments and the modified changes.

### [With Respect to Technique Associated with the Present Disclosure]

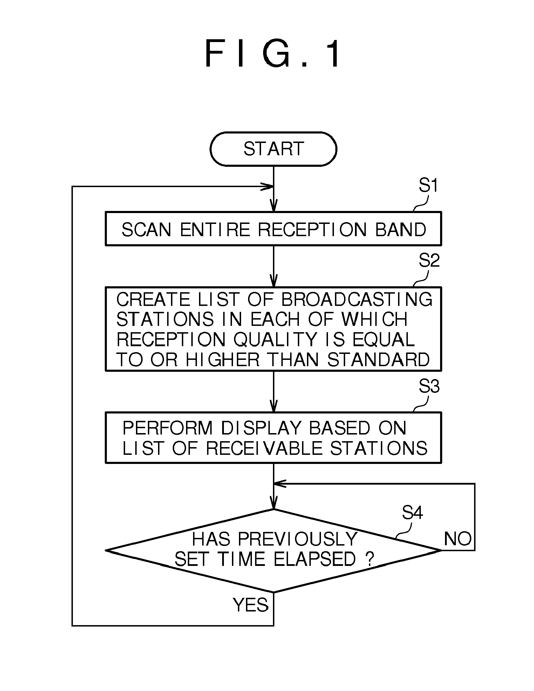

Firstly, a description will now be given with respect to processing executed in a radio receiving apparatus as a technique associated with the present disclosure. FIG. 1 is a flow chart explaining an example of predetermined pieces of processing executed in the radio receiving apparatus. The radio receiving apparatus, for example, is mounted to a vehicle.

Referring now to FIG. 1, in processing of Step S1, there is executed processing for scanning a reception band of a radio broadcasting every predetermined frequency step (scanning processing). Also, an operation proceeds to processing of Step S2. In the processing of Step S2, a list of broadcasting stations in each of which a quality of a received signal (reception quality) is equal to or higher than a standard is created in accordance with a result of the scanning processing. For example, when a strength of an electric field of the received signal is equal to or larger than a threshold value, the reception quality is determined to be equal to or larger than the standard. Also, the operation proceeds to processing of Step S3.

In the processing of Step S3, display based on the list is carried out and information corresponding to receivable broadcasting stations is displayed. A user can dial the desired broadcasting station from the information, corresponding to the broadcasting stations, which is displayed. Also, the operation proceeds to processing of Step S4. In the processing of Step S4, it is determined whether or not a previously set time has elapsed. When it is determined in the processing of Step S4 that the previously set time has not yet elapses, the operation returns back to the processing of Step S4. On the other hand, when it is determined in the processing of Step S4 that the previously set time has elapsed, the operation returns back to the processing of Step S1, and the scanning processing is executed again.

When the vehicle is moved, the reception environment temporarily becomes worse, for example, in a tunnel, an underground parking lot, a mountain area or the like in some cases. When the scanning processing in Step S1 is executed in the situation in which the reception environment temporarily becomes worse, it is determined that the quality of the received signal from a part of or all of the broadcasting stations do not meet the standard.

For this reason, in the processing of Step S2, a part of or all of the predetermined pieces of information corresponding to the broadcasting stations, which are displayed in the list become non-display. Even when the reception environment becomes satisfactory, the next scanning processing is not executed at all unless the previously set time elapses. None of the predetermined pieces of information corresponding to the broadcasting stations is displayed until after the previously set time has elapsed, the next scanning processing and the display processing based on the result of the scanning processing are completed. For this reason, there is caused a problem that it may be impossible for the user to carry out a manipulation for dialing.

In the present disclosure, for example, even when the quality of the received signal does not meet the standard, a part of or all of the predetermined pieces of information corresponding to the broadcasting stations is not caused to become the non-display, but is displayed in the form of a different display form. Hereinafter, the contents of the present disclosure will be described in detail.

### 1. First Embodiment

### [Configuration of Receiving Apparatus]

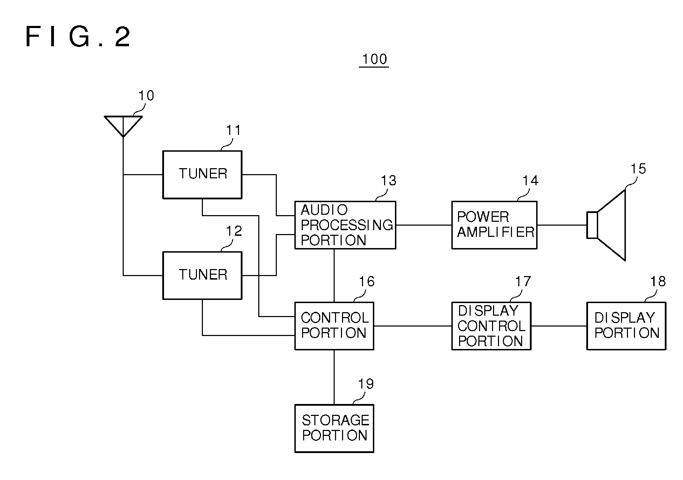

FIG. 2 is a block diagram showing a configuration of a receiving apparatus according to a first embodiment of the present disclosure (hereinafter suitably referred to as "a receiving apparatus 100"). The receiving apparatus 100 is an apparatus which, for example, is mounted to a vehicle and receives a radio wave. A mobile terminal or the like having a radio receiving function may be said as the receiving apparatus 100.

The receiving apparatus 100 includes an antenna 10 for receiving a broadcasting wave. Both of a tuner 11 and a tuner 12 are connected to the antenna 10. An audio processing portion 13 is connected to each of the tuner 11 and the tuner 12. A power amplifier 14 is connected to the audio processing portion 13. Also, a speaker 15 is connected to the power amplifier 14.

A control portion 16 is connected to each of the tuner 11 and the tuner 12. Both of a display control portion 17 and a storage portion 19 are connected to the control portion 16. Also, a display portion 18 is connected to the display control portion 17.

The tuner 11 includes a Radio Frequency (RF) amplifier, a tuning circuit, a mixer, an S meter detecting circuit, and an Analog to Digital Converter (ADC) circuit. In this case, the RF amplifier amplifies an RF signal supplied thereto from the antenna 10. The tuning circuit selects a frequency signal of a desired broadcasting station from the RF signal thus amplified. The mixer mixes a frequency signal supplied thereto from a local oscillator with the RF signal, thereby generating an Intermediate Frequency (IF) signal. The S meter detecting circuit DC-detects the intermediate frequency signal, thereby detecting a strength-of-electric field of a received signal (S meter signal) representing a strength of an electric field of a received signal. Also, the ADC circuit suitably converts the IF signal or the S meter signal from the analog signal into a digital signal.

In addition, the tuner 12 includes an RF amplifier, a tuning circuit, a mixer, an S meter detecting circuit, and an ADC circuit. In this case, the RF amplifier amplifies an RF signal supplied thereto from the antenna 10. The tuning circuit selects a frequency signal of a desired broadcasting station from the RF signal thus amplified. The mixer mixes the frequency signal supplied thereto from the local oscillator with the RF signal, thereby generating the IF signal. The S meter detecting circuit DC-detects the IF signal, thereby detecting the S meter signal representing the strength of the electric field of the received signal. Also, the ADC circuit suitably converts the IF signal or the S meter signal from the analog signal into the digital signal. The tuner 12, for example, can receive a broadcasting different from a broadcasting received by the tuner 11, in a background.

The IF signal converted into the digital signal is supplied to the audio processing portion 13. The S meter signal is supplied to the control portion 16. For example, the IF signal is supplied from the tuner 11 to the audio processing portion 13, and the S meter signal is supplied from the tuner 12 to the control portion 16. In such a manner, as an example, the tuner 12 is used to check the quality of the received signal. The S meter signal may be supplied from the tuner 11 to the control portion 16, and thus the tuner 11 may be used to check the quality of the received signal. In addition thereto, diversity reception may also be carried out by using both of the tuner 11 and the tuner 12.

The configurations of the tuner 11 and the tuner 12 are merely an example and thus are by no means limited to the configurations described above. The audio processing portion 13 or the control portion 16 may have a part of the configurations and the functions in the tuner 11 and the tuner 12. Moreover, the number of tuners is by no means limited two. Thus, a configuration may also be adopted such that the receiving apparatus 100 includes three or more tuners.

The audio processing portion 13 executes various kinds of pieces of signal processing for the IF signal supplied thereto from at least one of the tuner 11 and the tuner 12. The audio processing portion 13 executes Fast Fourier Transform (FFT) processing, digital filtering processing, de-interleave processing, decoding processing, level control processing, Digital to Analog Conversion (DAC) processing for converting a digital signal for which these pieces of processing described above are executed into an analog signal, and the like. Processing for carrying out the diversity reception may be executed by the audio processing portion 13. An analog audio signal is formed by the audio processing portion 13. The analog audio signal is then supplied to the power amplifier 14.

The power amplifier 14 amplifies the analog audio signal supplied thereto from the audio processing portion 13 at a predetermined amplification factor. It is noted that the power amplifier 14 may be composed of a digital amplifier. The analog audio signal amplified by the power amplifier 14 is supplied to the speaker 15.

The speaker 15 reproduces the analog audio signal supplied thereto from the power amplifier 14. As a result, the user of the receiving apparatus 100 can listen in the broadcasting of the desired broadcasting station. It is noted that when the receiving apparatus 100 is an in-vehicle radio receiving apparatus, the speaker 15, for example, is composed of a speaker (a center speaker) which is mounted to the vicinity of the center of a dashboard, and four speakers (a front right speaker, a front left speaker, a rear right speaker, and a rear left speaker) which are mounted to the vicinities of seats, respectively. Of course, a disposition form of the speaker is by no means limited to the form thus exemplified and thus can be suitably changed in accordance with a size, a shape, and the like of the vehicle.

The control portion 16, for example, is composed of a Central Processing Unit (CPU) and controls the individual portions of the receiving apparatus 100. The control portion 16 controls a dialing operation of the tuner 12 and thus executes processing for scanning the quality of the received signal in the background. That is to say, the control portion 16 functions as an example of a determining portion. The scanning processing is processing including at least processing for tuning a tuner to a predetermined frequency in a reception band of a broadcasting wave, thereby checking the quality of the received signal having the tuning frequency.

A description will now be given with respect to an example of the scanning processing. For example, the tuner 12 is tuned to a predetermined frequency in a reception band which is used in an Amplitude Modulation (AM) broadcasting or a Frequency Modulation (FM) broadcasting. An S meter signal representing a strength of an electric field of a received signal having a predetermined frequency is detected. The S meter signal thus detected is supplied to the control portion 16. The control portion 16 determines whether or not the quality of the received signal having the tuning frequency is equal to or higher than the standard based on the S meter signal.

After completion of the determining processing, a next frequency is set as the tuning frequency. It is determined whether or not the quality of the received signal having the tuning frequency thus set is equal to or higher than the standard. Since then, the same pieces of processing as those described above are executed for all of the tuning frequency in the reception band. It is noted that the tuning frequency in the scanning processing, for example, is set at an internal of a predetermined frequency from a low frequency toward a high frequency in the reception band.

In accordance with the result of the scanning processing, the control portion 16 creates a list based on the S meter signal. For example, the control portion 16 extracts the received signal in which the strength of the electric field represented by the S meter signal is equal to or larger than the predetermined value, and holds the extraction result. The list created by the control portion 16, for example, is stored in the storage portion 19.

The control portion 16 generates a display control signal in such a way that the display based on the list is carried out. The display control signal generated by the control portion 16 is supplied to the display control portion 17. It is noted that although an illustration is omitted here, the control portion 16 has timer(s). Although details will be described later, counting-up of the timer can be started every item of the list. In addition thereto, a configuration is adopted such that the counting-up can be stopped every timer, and thus a count value can be reset.

The receiving apparatus 100 includes both of the display control portion 17 and the display portion 18 in terms of a display system. The display control portion 17 functions as a driver for driving the display portion 18. The display control portion 17, for example, drives the display portion 18 in accordance with the display control signal supplied thereto from the control portion 16. The display portion 18 is composed of a character display device in which plural segments are arranged, a Liquid Crystal Display (LCD) panel, an organic Electroluminescence (EL) panel or the like.

The display is carried out in the display portion 8 in accordance with the display control signal. Information corresponding to the broadcasting stations, for example, is displayed in the form of a list on the display portion 18. The information corresponding to the broadcasting stations, for example, is names of the broadcasting stations. The display other than the display carried out in accordance with the display control signal may also be carried out in the display portion 18. It is noted that the list, of the names of the broadcasting stations, which is actually displayed on the display portion 18 is referred to as the display list in some cases.

The information corresponding to the broadcasting station in which the quality of the received signal is equal to or higher than the predetermined quality is displayed in the form of a first display form on the display portion 18. The information corresponding to the broadcasting station in which the quality of the received signal is equal to or higher than the predetermined quality, for example, is displayed in a lighting style like a normal display form. On the other hand, the information corresponding to the broadcasting station in which the quality of the received signal is determined to be lower than the predetermined quality is displayed in the form of a second display form different from the first display form. For example, the information corresponding to the broadcasting station in which the quality of the received signal is determined to be lower than the predetermined quality is displayed with a display color different from that in the normal display form.

It is noted that with regard to the contents of the display list displayed on the display portion 18, for example, the following contents can be given. The switching of the contents of the display list, for example, is controlled in accordance with the display control signal generated by the control portion 16.
1) All of the names of the broadcasting stations are displayed in the first display form.
2) All of the names of the broadcasting stations are displayed in the second display form.
3) The names of the broadcasting stations displayed in the first display form, and the names of the broadcasting stations displayed in the second display form are present in a mixed style.
4) All of the names of the broadcasting names become non-display.

The storage portion 19, for example, is composed of a nonvolatile memory. The list created by the control portion 16 is stored in the storage portion 19. It is noted that the information, on the broadcasting stations, which is adapted to be preset by the user may be stored in the storage portion 19. Also, the names of the broadcasting stations which are adapted to be preset may be displayed on the display portion 18.

It is noted that although an illustration is omitted here, the receiving apparatus 100 is provided with a manipulation portion. A manipulation signal corresponding to a manipulation carried out with the manipulation portion is generated. The manipulation signal thus generated is then supplied to the control portion 16. The control portion 16 executes the processing corresponding to the manipulation signal supplied thereto.

The manipulation portion, for example, is composed of a switch, a dial, a button, and the like which are disposed in the dashboard. In the first embodiment of the present disclosure, as an example, the display portion 18 in the receiving apparatus 100 is configured in the form of a touch panel. For example, the information corresponding to the broadcasting station and displayed on the display portion 18 is touched to select the information corresponding to the broadcasting station. The tuner 11 is controlled by the control portion 16 in such a way that a signal from the broadcasting station thus selected is received. The broadcasting station name which is displayed on the display portion 18 is selected in such a manner, thereby making it possible to dial the broadcasting station concerned. The information corresponding to the broadcasting station, for example, may be selected by using a button or a remote controller. It is noted that the broadcasting station name which is displayed on the display portion 18 can be selected irrespective of the first and second display forms.

An audio source which is stored in a hard disk, a Compact Disk (CD), a semiconductor memory or the like may be reproduced by the audio processing portion 13. In addition thereto, a configuration may also be adopted such that the receiving apparatus 100 has a communication function of making a communication with an external apparatus.

### [Operation of Receiving Apparatus]

A description will be given below with respect to an operation of the receiving apparatus 100. The control portion 16 executes the first round of the scanning processing (initial scanning) by, for example, controlling the tuner 12. By executing the initial scanning processing, for example, the frequency of the received signal in which the strength of the electric field is equal to or larger than the predetermined value is extracted. The information on the extracted frequency, and the name of the broadcasting station which broadcasts the broadcasting signal having the frequency thus extracted are both held in the list. The quality of the received signal is checked for the received signals having all of the tuning frequencies in the reception band.

The control portion 16 generates the display control signal in accordance with which the names of the broadcasting stations held in the list are displayed. The display control signal generated by the control portion 16 is supplied to the display control portion 17. The display control portion 17 drives the display portion 18 in accordance with the display control signal. The names of the broadcasting stations as an example of the information corresponding to the broadcasting stations are displayed on the display portion 18. After a lapse of the previously set time, the scanning processing is executed again. The previously set time, for example, is one minutes. In such a manner, the scanning processing is periodically executed.

Now, when the vehicle is moved through the underground parking lot, the tunnel or the like, the reception environment of the receiving apparatus 100 temporarily becomes worse in some cases. It is supposed that in such cases, for example, the scanning processing is executed. Along with that the reception environment of the receiving apparatus 100 temporarily becomes worse, the strength of the electric field of the received signal is reduced. With the technique associated with the present disclosure described above, since the strength of the electric field of the received signal is reduced, the processing for inhibiting the corresponding broadcasting station from being dialed is executed. For example, the name or the like of the broadcasting station displayed on the display portion is made non-display. However, even when the reception environment is recovered, it may be impossible to select the broadcasting station name which is made non-display until the next scanning processing is completed.

Then, in the first embodiment of the present disclosure, even when the quality of the received signal is reduced, for example, the broadcasting station name is not immediately made non-display, but the broadcasting station name concerned is continuously displayed for a given period of time. At this time, the name or the like of the broadcasting station in which the quality of the received signal is determined to be lower than the predetermined quality is displayed in the second display form on the display portion 18 in such a way that the user can recognize that the quality of the received signal has been reduced. On the other hand, the name or the like of the broadcasting station in which the quality of the received signal is determined to be equal to or higher than the predetermined quality is displayed in the normal display form as an example of the first display form on the display portion 18. The switching of the first and second display forms is carried out in accordance with the display control signal generated by the control portion 16. It is noted that it is referred to as the display as a gray list in some cases to display the name or the like of the broadcasting station in the second display form on the display portion 18.

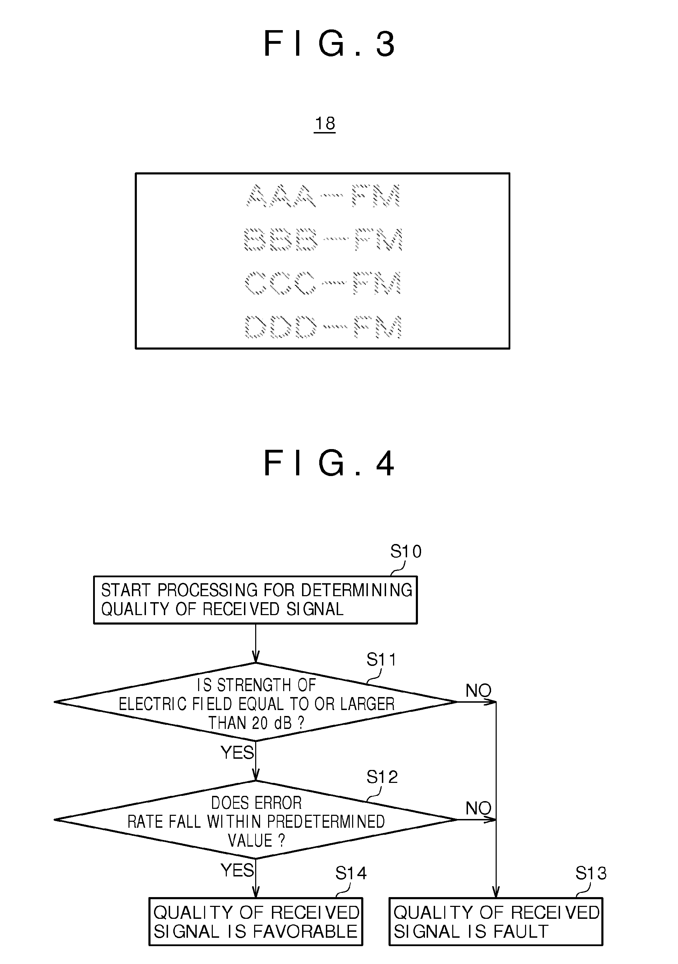

For example, as exemplified in FIG. 3, the radio broadcasting station names: the broadcasting station name AAA-FM; the broadcasting station name BBB-FM; the broadcasting station name CCC-FM; the broadcasting station name DDD-FM are all displayed in the form of the gray list.

It is supposed that the vehicle is moved so as to leave the underground parking lot, the tunnel or the like, so that the reception environment is recovered. The broadcasting station name is displayed in the form of the gray list on the display portion 18. For this reason, the user selects the broadcasting station name which is being displayed in the form of the gray list, thereby making it possible to immediately dial the desired broadcasting station. After the reception environment has been satisfactorily recovered, the scanning processing is executed again. Thus, the user can be prevented from waiting for a period of time for which the display processing based on the result of the scanning processing has been completed.

The control portion 16 executes the processing for tuning the tuner 11 to the frequency corresponding to the broadcasting station name selected, thereby receiving the broadcasting signal from the broadcasting station selected. After the predetermined signal processing has been executed for the broadcasting signal thus received by both of the audio processing portion 13 and the power amplifier 14, the broadcasting which the user desires to select is reproduced from the speaker 15.

### [Processing for determining Quality of Received Signal]

A description will be given below with respect to an example of processing executed by the receiving apparatus 100. Firstly, a description will now be given with respect to an example of processing, for determining the quality of the received signal, which is executed by the receiving apparatus 100 (hereinafter suitably referred to as "the quality determining processing" in some cases). The quality determining processing, for example, is executed by the control portion 16.

FIG. 4 is a flow chart showing an example of a flow of the quality determining processing. In the processing of Step S10, the quality determining processing is started. For example, the S meter signal is supplied from the tuner 12 to the control portion 16.

In processing of Step S11, it is determined whether or not the strength of the electric field, of the received signal, represented by the S meter signal is equal to or higher than the predetermined value. The predetermined value, for example, is set to 20 dB. When it is determined in the processing of Step S11 that the strength of the electric field of the received signal is lower than the predetermined value of 20 dB, an operation proceeds to processing of Step S13, and it is determined that the quality of the received signal is lower than the predetermined quality (fault). On the other hand, when it is determined in the processing of Step S11 that the strength of the electric field of the received signal is equal to or higher than the predetermined value of 20 dB, the operation proceeds to the processing of Step S12.

In the processing of Step S12, it is determined whether or not an error rate of the received signal falls within a predetermined value. When it is determined in the processing of Step S12 that the error rate of the received signal is larger than the predetermined value, the operation proceeds to processing of Step S13, and it is determined that the quality of the received signal is lower than a predetermined quality. On the other hand, when it is determined in the processing of Step S12 that the error rate of the received signal falls within the predetermined value, the operation proceeds to processing of Step S14. In the processing of Step S14, it is determined that the quality of the received signal is equal to or higher than the predetermined quality (favorable).

It is noted that, for example, the quality of the received signal may be determined by using noise information such as an amount of high-frequency noise, a reduction amount of signal based on a multiple paths, or a Carrier Noise Ratio (C/N Ratio) in addition to the error rate. Or, the quality of the received signal may be determined in accordance with the determination for only the strength of the electric field.

### 2. Second Embodiment

### [Flow of Processing]

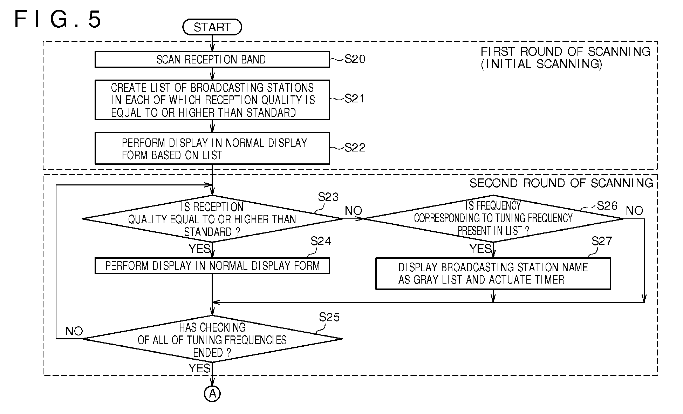

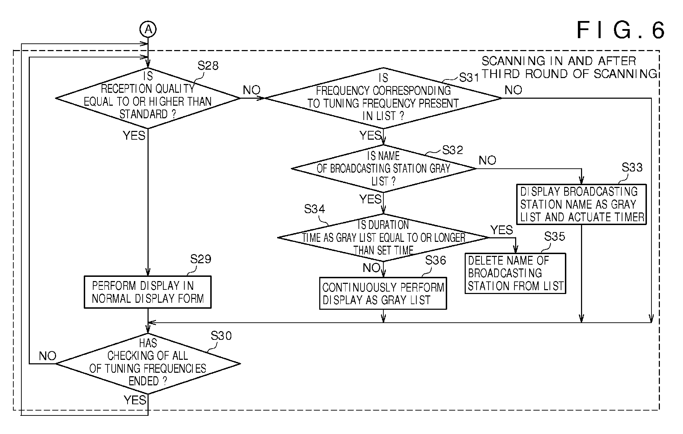

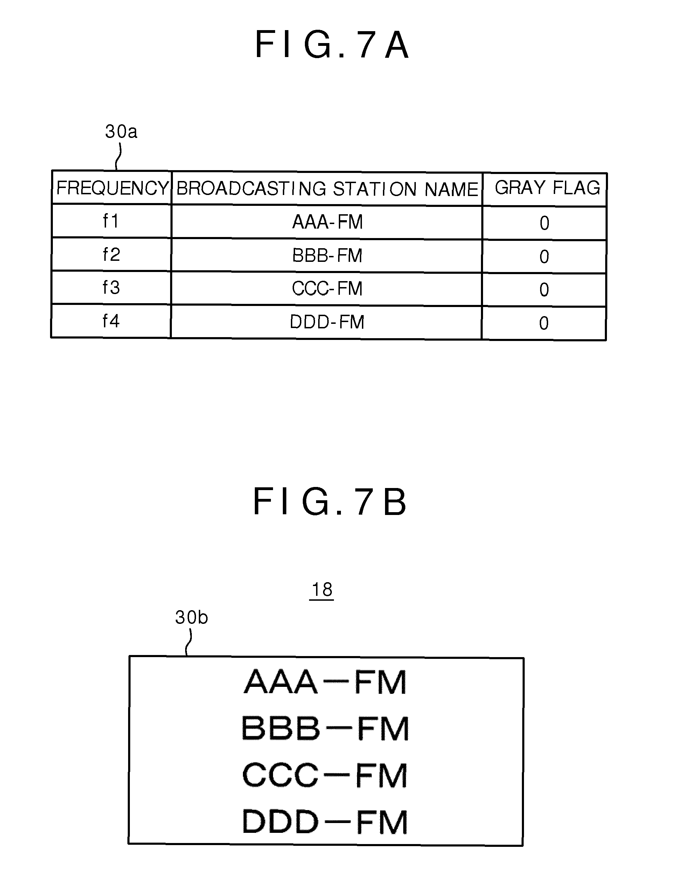

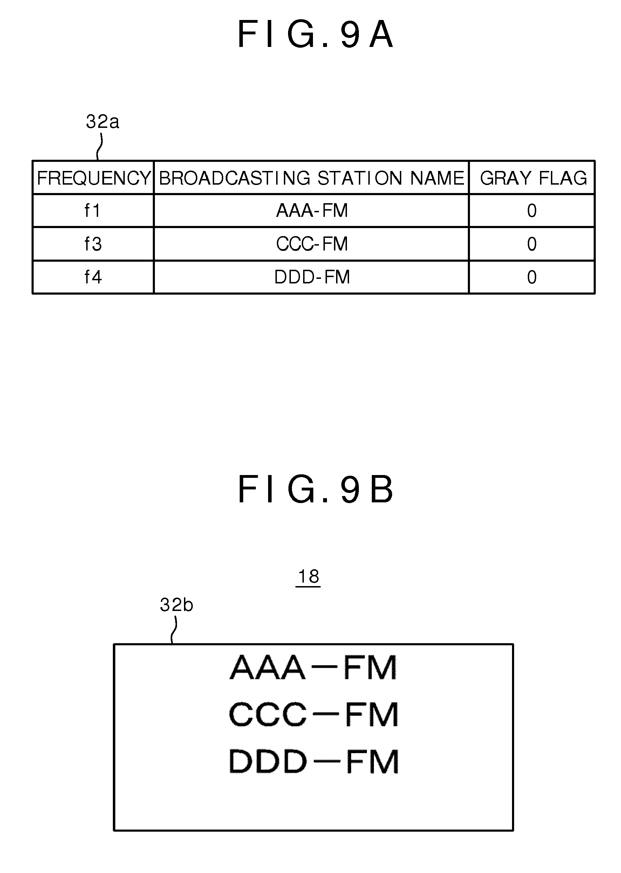

A description will now be given with respect to the processing in a display method according to a second embodiment of the present disclosure with reference to FIG. 5 to FIGS. 9A and 9B. FIGS. 5 and 6 are respectively flow charts showing a flow of the processing in the display method according to a second embodiment of the present disclosure. FIGS. 7A and 7B, FIGS. 8A and 8B, and FIGS. 9A and 9B each show an example of the list created in accordance with the control made by the control portion 16, and the display list based on the list. The processing shown in FIGS. 5 and 6 is started to be executed when, for example, an ignition key of the vehicle is rotated, and thus an accessory power is supplied to the receiving apparatus 100. It is noted that the predetermined pieces of processing are executed in accordance with the control made by the control portion 16 unless otherwise stated.

In FIG. 5, processing of Step S20, processing of Step S21, and processing of Step S22 show the first round of the scanning processing (initial scanning processing). In the processing of Step S20, there is executed the processing for scanning the reception band at a step of a predetermined frequency. Thus, the tuner 12 is turned to the predetermined frequency in the reception band, thereby receiving the signal having the predetermined frequency (tuning frequency). The reception band differs depending on the received broadcastings such as the AM broadcasting and the FM broadcasting. In this case, the description will be given below on the assumption that the FM broadcasting is received by the receiving apparatus 100. Also, an operation proceeds to processing of Step S21.

In the processing of Step S21, the quality determining processing is executed for the received signal having the tuning frequency. The tuning frequency in which the quality of the received signal is equal to or higher than the predetermined quality is extracted and the information on the tuning frequency thus extracted is held in the list. In addition thereto, the name of the broadcasting station corresponding to the extracted tuning frequency is held in the list. The tuning frequency is set for the reception band every predetermined frequency step. The quality determining processing is executed for the received signal having the tuning frequency thus set while the setting of the tuning frequency is updated. After the quality determining processing executed for all of the tuning frequencies in the reception band has ended, the list is created. The list thus created is stored in the storage portion 19. Also, the operation proceeds to processing of Step S22.

In the processing of Step S22, processing for the display based on the list is executed. For example, the names of the broadcasting stations included in the list are displayed on the display portion 18. In this case, the names of the broadcasting stations included in the list are displayed in the normal display form on the display portion 18.

A description will now be given by using a concrete example with reference to FIGS. 7A and 7B. FIG. 7A shows an example of the list stored in the storage portion 19. A list 30a is created by executing the processing of Step S21. The qualities of the receiving signals having a frequency f1, a frequency f2, a frequency f3, and a frequency f4, respectively, for example, are each determined to be equal to or higher than the standard based on the quality determining processing in the initial scanning processing. The name of the broadcasting station allocated to the frequency f1, for example, is assumed to be "AAA-FM." The name of the broadcasting station allocated to the frequency f2, for example, is assumed to be "BBB-FM." The name of the broadcasting station allocated to the frequency f3, for example, is assumed to be "CCC-FM." Also, the name of the broadcasting station allocated to the frequency f4, for example, is assumed to be "DDD-FM."

Gray flags are set in items of the list 30a, respectively. The gray flag is either 0 or 1 as a logical value. When the quality of the received signal is determined to be equal to or higher than the predetermined quality, the gray flag is set 0. In the list 30a obtained by executing the initial scanning processing, all of the gray flags are set to 0. On the other hand, when the quality of the received signal is determined to be lower than the predetermined quality, the gray flag is set to 1. A procedure may also be adopted such that when the quality of the received signal is determined to be equal to or higher than the predetermined quality, the gray flag is set to 1, while when the quality of the received signal is determined to be lower than the predetermined quality, the gray flag is set to 0.

FIG. 7B shows an example of the display list which is displayed on the display portion 18 based on the list 30a. A display list 30b is displayed on the display portion 18 based on the list 30a. Thus, it is possible to select any of the names of the broadcasting stations which are displayed in the display list 30b. For example, when the user desires to select the broadcasting station BBB-FM, there is carried out a manipulation for selecting a position where the broadcasting station name BBB-FM is displayed. A manipulation signal corresponding to the manipulation for the selection is supplied to the control portion 16.

The control portion 16 controls the tuner 11 in such a way that, for example, the tuner 11 receives the broadcasting signal having the frequency f2. The broadcasting signal having the frequency f2 is received by the tuner 11 in accordance with this control. Both of the audio processing portion 13 and the power amplifier 14 execute predetermined processing for the broadcasting signal thus received. The broadcasting signal for which the predetermined processing has been executed is reproduced from the speaker 15. That is to say, the broadcasting signal from the broadcasting station BBB-FM is reproduced from the speaker 15.

Referring back to FIG. 5, the flow of the processing is continuously described. A lapse of a previously set period of time after completion of the processing of Step S22, next scanning processing (second round of the scanning processing) is executed. A time interval between the scanning processing and the next scanning processing, for example, is set to one minute.

Five pieces of processing: processing of Step S23; processing of Step S24; processing of Step S25; processing of Step S26; and processing of Step S27 in FIG. 5 show the second round of the scanning processing. In the processing of Step S23, the tuner 12 is tuned to the predetermined frequency in the reception band, and thus there is executed the quality determining processing for the received signal having the tuning frequency. When the quality of the received signal is determined to be equal to or higher than the standard, the operation proceeds to processing of Step S24. In the processing of Step S24, the display in the normal display form for the name of broadcasting station corresponding to the tuning frequency is continuously carried out. Also, the operation proceeds to processing of Step S25.

In the processing of Step S25, it is determined whether or not the quality determining processing has been executed for the received signals having all of the tuning frequencies in the reception band, respectively. That is to say, it is determined whether or not the quantities of the received signals having all of the tuning frequencies in the reception band, respectively, have been checked. When an affirmation result is obtained in the determination processing in Step S25, the operation proceeds to processing of Step S28 in FIG. 6. On the other hand, when a negation result is obtained in the determination processing in Step S25, the operation returns back to the processing of Step S23. Also, a next tuning frequency is set, and the quality determining processing is executed for the received signal having the tuning frequency thus set. Note that, although in FIG. 5, "A" is described after the processing of Step S25, this description represents the continuity to predetermined pieces of processing in FIG. 6, and thus does not represent special processing.

When it is determined in the processing of Step S23 that the quality of the received signal is lower than the predetermined quality, the operation proceeds to processing of Step S26. In the processing of Step S26, it is determined whether or not the frequency corresponding to the tuning frequency set in the processing of Step S23 is present in the list 30a. When it is determined in the processing of Step 26 that the frequency corresponding to the tuning frequency set in the processing of Step S23 is absent in the list 30a, the operation proceeds to processing of Step S25. In this case, since it is determined that the quality of the received signal is lower than the predetermined quality in the initial scanning as well, the special processing is not executed, and the operation proceeds to the processing of Step S25. On the other hand, when it is determined in the processing of Step S26 that the frequency corresponding to the tuning frequency set in the processing of Step S23 is present in the list 30a, the operation proceeds to processing of Step S27.

In the processing of Step S27, the names of the broadcasting stations each of which the quality of the received signal is lower than the predetermined quality are displayed in the form of the gray list. In addition, in the processing of Step S27, the timer which the control portion 16 has is actuated, and the counting-up is started. Also, the operation proceeds to the processing of Step S25. As previously stated, in the processing of Step S25, it is determined whether or not the checking of the qualities for the received signals having all of the tuning frequencies has ended. When it is determined in the processing of Step S25 that the checking of the qualities for the received signals having all of the tuning frequencies has ended, the operation proceeds to processing of Step S28 in FIG. 6. On the other hand, when it is determined in the processing of Step S25 that the checking of the qualities for the received signals having all of the tuning frequencies has not yet ended, the operation returns back to the processing of Step S23.

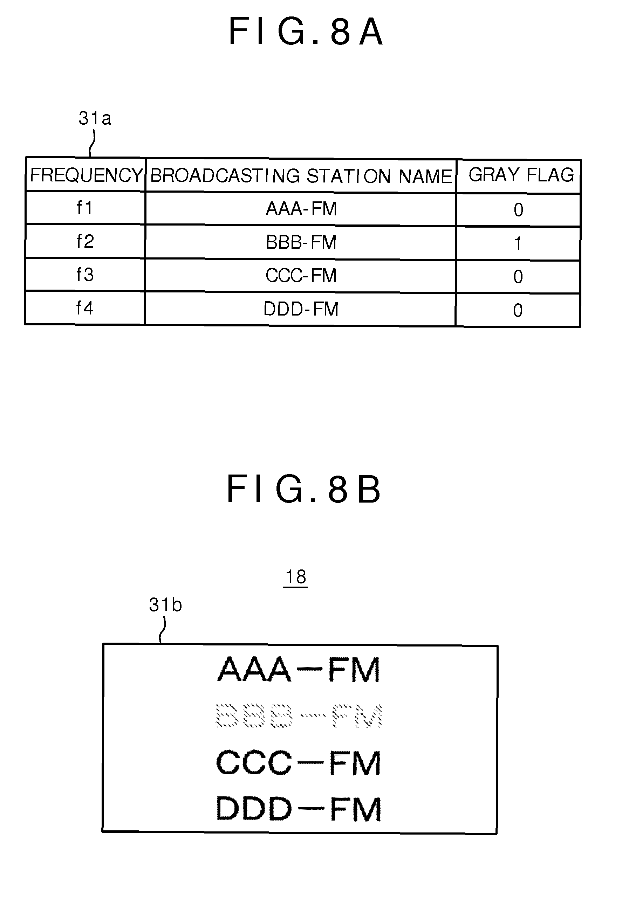

A concrete example will now be described below with reference to FIGS. 8A and 8B. It is supposed that, for example, in the processing of Step S23, the quality of the received signal having the frequency f2 as the tuning frequency is lower than the standard. The frequency f2 is present in the list 30a generated by executing the initial scanning processing. As exemplified in FIG. 8A, the control portion f2 changes the gray flag which is set for the frequency f2 and the broadcasting station name BBB-FM from 0 to 1. In addition, the control portion 16 actuates the timer associated with both of the frequency f2 and the broadcasting station name BBB-FM.

FIG. 8B shows an example of a display list 31b based on the list 31a. The broadcasting station name BBB-FM for which the gray flag is set to 1 is displayed in the form of a display form different from the normal display form. For example, the broadcasting station name AAA-FM and the broadcasting station name BBB-FM are displayed with different colors, respectively. The broadcasting station names are displayed with the different forms, respectively, whereby the user can recognize that the quality of the broadcasting from the broadcasting station name BBB-FM is reduced.

Referring back to FIGS. 5 and 6, the flow of the processing will be continuously described below. Nine pieces of processing: the processing of Step S28; the processing of Step S29; the processing of Step S30; the processing of Step S31; the processing of Step S32; the processing of Step S33; the processing of Step S34; the processing of Step S35; and the processing of Step S36 show scanning processing which is executed in and after the third round of the scanning processing.

The scanning processing in and after the third round of the scanning processing is executed after the affirmation result is obtained in the determining processing of Step S27 and a predetermined period has passed. The scanning processing in and after the third round of the scanning processing, for example, is continuously executed until an ignition key of the vehicle is rotated and thus the supply of the electric power from the accessory power source is stopped.

In the processing of Step S28, the quality determining processing is executed. That is to say, the tuner 12 is tuned to the predetermined frequency in the reception band and thus it is determined whether or not the quantity of the received signal having the tuning frequency is equal to or higher than the standard. When it is determined in the processing of Step S28 that the quantity of the received signal having the tuning frequency is equal to or higher than the standard, the operation proceeds to processing of Step S29. In the processing of Step S29, the displaying of the broadcasting station name corresponding to the tuning frequency in the normal display form is continuously carried out. Also, the operation proceeds to processing of Step S30.

In the processing of Step S30, it is determined whether or not the quantities of the received signals having all of the tuning frequencies have been checked. When a negation result is obtained in the processing of Step S30, the operation returns back to the processing of Step S28. In the processing of Step S28, the next tuning frequency is set, and the tuner 12 is tuned to the tuning frequency concerned. Also, it is determined whether or not the quality of the received signal having the tuning frequency is equal to or higher than the standard. On the other hand, when the affirmation result is obtained in the processing of Step S30, the operation returns back to the processing of Step S28. For example, after a lapse of one minute, the fourth round of the scanning processing is executed. When the affirmation result is obtained in the processing of Step S30 after a lapse of the set time in such a manner, next round of scanning processing is executed after a lapse of the set time.

When it is determined in the processing of Step S28 that the quality of the received signal is lower than the standard, the operation proceeds to processing of Step S31. In the processing of Step S31, it is determined whether or not the frequency corresponding to the tuning frequency in the processing of Step S28 is present in the list which was created in the last-minute scanning processing. When it is determined in the processing of Step S31 that the frequency corresponding to the tuning frequency in the processing of Step S28 is absent in the list which was created in the last-minute scanning processing, the operation proceeds to processing of Step S30. In this case, since the quality of the received signal is determined to be lower than the predetermined quality in the last-minute scanning processing as well, no special processing is executed and the operation proceeds to the processing of Step S30.

When it is determined in the processing of Step S31 that the frequency corresponding to the tuning frequency in the processing of Step S28 is present in the list which was created in the last-minute scanning processing, the operation proceeds to processing of Step S32. In the processing of Step S32, the gray flag in the list is discriminated, and it is determined whether or not the broadcasting station name is the gray list. When it is determined in the processing of Step S32 that the broadcasting station name is not the gray list, that is, that the gray flag is 0, the operation proceeds to processing of Step S33. In the processing of Step S33, the gray flag in the list is set to 1, and the names of the broadcasting stations in each of which the gray flag is set to 1 are displayed in the form of the gray list. In the processing of Step S33, the timer is further actuated. Also, the operation proceeds to processing of Step S30. The contents of the processing of Step S30 are as described above.

When in the determination processing in Step S32, the broadcasting station name is the gray list, that is, when the gray flag is 1, the operation proceeds to processing of Step S34. In the processing of Step S34, it is determined whether or not a time for which the broadcasting station name is displayed in the form of the gray list is equal to or larger than the set time. Although the set time can be suitably changed, for example, the set time is set to one hour. It is noted that the set time may be set by the user. In addition, a Global Positioning System (GPS) sensor may be provided in the vehicle, and the set time may be set in accordance with the information obtained from the GPS sensor. For example, when the vehicle is located in a place, such as a border between countries or a border between prefectures, where the possibility that the reception area is changed is high, the set time may be shortened (for example, about 10 minutes).

When the broadcasting station name is continuously displayed in the form of the gray list for more than the set time, the operation proceeds to processing of Step S35. In the processing of Step S35, the broadcasting station name which is displayed in the form of the gray list for more than the set time is deleted from the list. The broadcasting station name which is deleted from the list is also deleted from the display list in the display portion 18.

The displaying of the broadcasting station name in the form of the gray list for more than the set time means that the quality of the received signal is lower than the standard for more than the set time. That is to say, it is possible to determine that the reception environment of the received signal does not temporarily become worse, but the vehicle is moved to the area in which it may be impossible to receive the received signal concerned. In such a case, it is unnecessary to display the broadcasting station name in the display list. Therefore, the broadcasting station name, and the like are deleted from the list, and the broadcasting station name is deleted from the display list.

On the other hand, when it is determined in the processing of Step S34 that the time for which the broadcasting station name is displayed in the form of the gray list is shorter than the set time, the operation proceeds to processing of Step S36. In the processing of Step S36, the displaying of the broadcasting station name in the form of the gray list is continuously carried out. Also, the operation proceeds to the processing of Step S30. The contents of the processing of Step S30 are as described above.

Concrete examples will be described below with reference to FIGS. 8A and 8B, and FIGS. 9A and 9B. As shown in FIG. 8A, the gray flag corresponding to the frequency f2 and the broadcasting station name BBB-FM is set to 1. As exemplified in FIG. 8B, the broadcasting station name BBB-FM is displayed in the form of the gray list is displayed in the form of the gray list. After such a list has been created and thus the display list is displayed, N-th (N: integer number of three or more) round of the scanning processing is executed.

In Step S28 of the N-th round of the scanning processing, the frequency f2 is set as the tuning frequency. It is supposed that the quality of the received signal having the frequency f2 is lower than the standard. Since the frequency f2 is present in the list 31a, the affirmation result is obtained in the determination processing in Step S31. Also, since the frequency f2 and the broadcasting station name BBB-FM are both displayed in the form of the gray list, the affirmation result is obtained in the determination processing in Step S32.

When in processing of Step S34, the broadcasting station name BBB-FM is continuously displayed in the form of the gray list for more than the set time, processing of Step S35 is executed and thus the broadcasting station name BBB-FM is deleted. As shown in FIG. 9A, the frequency f2 and the broadcasting station name BBB-FM are both deleted from the list 31a, and a list 32a is newly created. The display list based on the list 32a is displayed on the display portion 18. As exemplified in FIG. 9B, a display list 32b which is obtained by deleting the broadcasting station name BBB-FM from the list 31a is displayed on the display portion 18.

On the other hand, when in the processing of Step S34, the broadcasting station name BBB-FM is not continuously displayed in the form of the gray list for more than the set time, processing of Step S36 is executed. Also, in the processing of Step S36, the broadcasting station name BBB-FM is continuously displayed in the form of the gray list.

As has been described so far, even when the quality of the received signal is lower than the standard, the name of the broadcasting station from which a program based on the received signal concerned is broadcasted is not immediately deleted from the display list, but is displayed in the form of the gray list. When the reception environment of the received signal is satisfactorily recorded, the broadcasting station name which is displayed in the form of the gray list is selected, thereby making it possible to immediately dial the broadcasting station concerned. Of course, the broadcasting station from which a program based on the received signal whose quality is equal to or higher than the standard is broadcasted may be dialed. The broadcasting station names are displayed in the form of the different display forms in correspondence to the qualities of the received signals, respectively. For this reason, the user can readily identify any of the names of the broadcasting stations in each of which the quality of the received signal is equal to or higher than the standard, and thus can select the desired name of the broadcasting station from such names of the broadcasting stations.

In addition thereto, when the broadcasting station name is continuously displayed in the form of the gray list for more than the set time on the display portion 18, the broadcasting station name, and the like are deleted from both of the list and the display list. As a result, for example, the broadcasting station which is located outside the reception area can be prevented from being displayed more than necessary.

### 3. Third Embodiment

Next, a description will be given below with respect to a display method according to a third embodiment of the present disclosure. Since a configuration of a receiving apparatus in the third embodiment of the present disclosure is the same as that of the receiving apparatus 100 in each of the first and second embodiments of the present disclosure, a repeated description is omitted here for the sake of simplicity.

### [Flow of Processing]

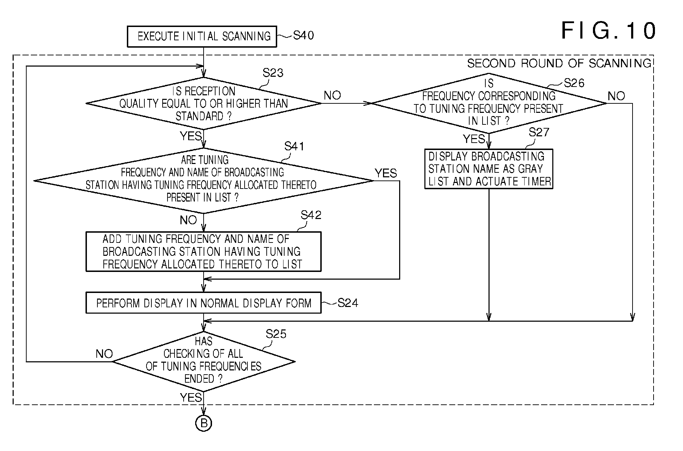

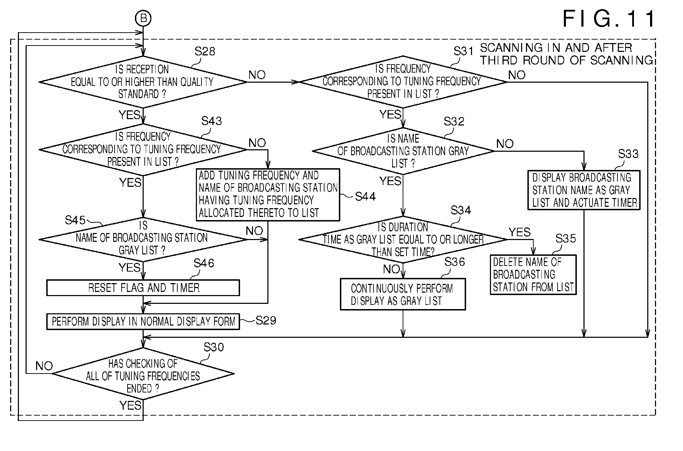

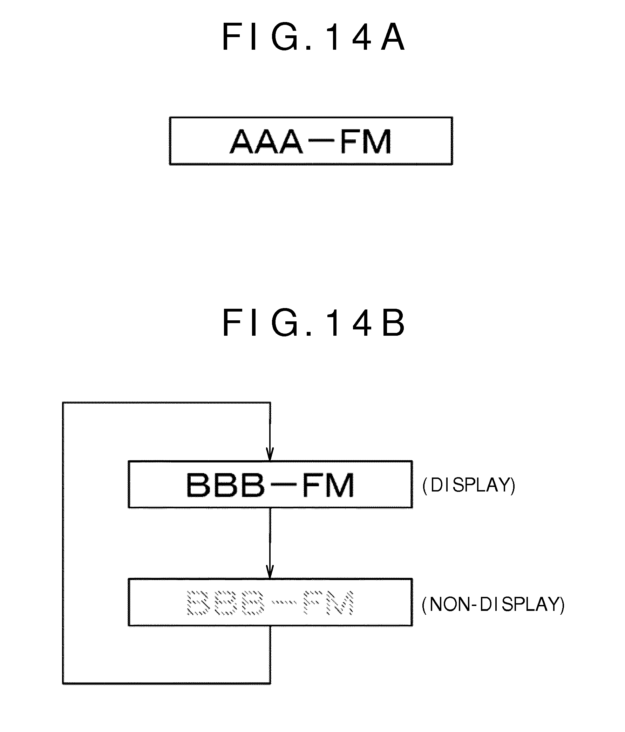

A description will be given with respect to flow of processing in the display method according to the third embodiment of the present disclosure with reference to FIG. 10 to FIGS. 14A and 14B. FIGS. 10 and 11 are respectively flow charts showing the flow of the processing in the display method according to the third embodiment of the present disclosure. It is noted that in the flow charts shown in FIGS. 10 and 11, the same pieces of processing as those of processing in the second embodiment are designated by the same reference symbols, respectively. In the following, the description will be given with emphasis on predetermined pieces of processing which are different from those of processing in the display method according to the second embodiment of the present disclosure.

In processing of Step S40 in FIG. 10, the initial scanning processing is executed. The contents of the initial scanning processing are the same as those of the three pieces of processing in FIG. 9: the processing of Step S20; the processing of Step S21; and the processing of Step S22. Also, the second round of the scanning processing is executed.

In the second round of the scanning processing, for example, two pieces of processing in Step S41 and Step S42 are added. In the processing of Step S23, it is determined whether or not the quality of the received signal having a certain tuning frequency is equal to or higher than the standard. When it is determined in the processing of Step S23 that the quality of the received signal having the certain tuning frequency is lower than the standard, the operation proceeds to the processing of Step S26. It is noted that since the contents of the two pieces of processing in Step S26 and Step S27 are the same as those in the display method according to the second embodiment of the present disclosure, a repeated description is omitted here for the sake of simplicity.

When an affirmation result is obtained in the determination processing of Step S23, the operation proceeds to processing of Step S41. In the processing of Step S41, it is determined whether or not the tuning frequency becoming the object of the determination in the processing of Step S23, and the broadcasting station name having the tuning frequency concerned allocated thereto are present in the list. When it is determined in the processing of Step S41 that the tuning frequency becoming the object of the determination in the processing of Step S23, and the broadcasting station name having the tuning frequency concerned allocated thereto are present in the list, the operation proceeds to the processing of Step S24, and both of the frequency and the broadcasting station name are displayed in the normal display form. On the other hand, when the tuning frequency becoming the object of the determination in the processing of Step S23, and the broadcasting station name having the tuning frequency concerned allocated thereto are absent in the list, the operation proceeds to processing of Step S42.

In the processing of Step S42, the tuning frequency becoming the object of the determination in the processing of Step S23, and the broadcasting station name having the tuning frequency concerned allocated thereto are added to the list. Also, the broadcasting station name added to the list is displayed in the normal display form.

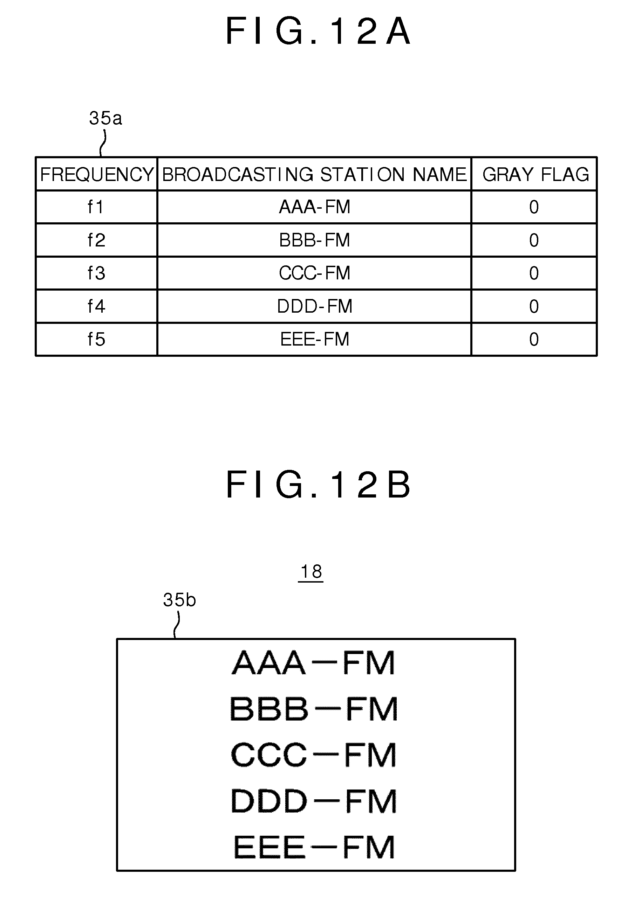

The predetermined pieces of processing in Step S41, Step S42, and the like will now be concretely described below with reference to FIGS. 7A and 7B, and FIGS. 12A and 12B. For example, by executing the initial scanning processing in Step S40, the list 30a exemplified in FIG. 7A is created. The display list 30b is displayed on the display portion 18 based on the list 30a.

In the processing in Step S23, in the second round of the scanning processing, a frequency f5 is set as the tuning frequency. When it is determined in the processing of Step S23 that the quality of the received signal corresponding to the frequency f5 is determined to be equal to or higher than the standard, the processing of Step S41 is executed. Both of the frequency f5 and the broadcasting station name having the frequency f5 allocated thereto are absent in the list 30a. For this reason, the addition processing of Step S42 is executed.

In the addition processing of Step S42, there is executed the processing for adding both of the frequency f5 and the broadcasting station name having the frequency f5 allocated thereto to the list 30a. As exemplified in FIG. 12A, both of the frequency f5 and the broadcasting station name EEE-FM having the frequency f5 allocated thereto are added to the list 30a, and thus a new list 35a is created. Since the quality of the received signal having the frequency f5 is equal to or higher than the standard, the gray flag is set to 0.

Also, the processing of Step S24 is executed. In the processing of Step S24, the display list based on the list 35a is displayed on the display portion 18. As exemplified in FIG. 12B, a display list 35b to which the broadcasting station name EEE-FM is added is displayed on the display portion 18. As a result, the broadcasting station name EEE-FM can be selected. When the broadcasting station name EEE-FM is selected by the user, the control portion 16 carries out the control in accordance with which the tuner 12 is tuned to the frequency f5, and the broadcasting from the broadcasting station name EEE-FM is reproduced.

Since the reception area is changed along with the movement of the vehicle, the broadcasting wave from the new broadcasting station can be received in some cases. In such cases as well, the name of the broadcasting station from which the broadcasting wave can be received is automatically added to each of the list and the display list. Thus, it is unnecessary for a driver to carry out the manipulation for seeking the broadcasting station, or the manipulation for presetting the broadcasting station along with the change in the reception area. For this reason, the safety in the driving is improved.

Referring back to FIG. 10, the flow of the processing is continuously described below. When the affirmation result is obtained in the processing of Step S25 in the second round of the scanning processing, scanning processing in and after the third round of the scanning processing is executed. Note that, although in FIG. 10, "B" is described after the processing of Step S25, this description represents the continuity to predetermined pieces of processing in FIG. 11 which will be described below, and does not represent the special processing.

FIG. 11 shows the scanning processing in and after the third round of the scanning processing. In the scanning processing in and after the third round of the scanning processing, four pieces of processing: processing of Step S43; processing of Step S44; processing of Step S45; and processing of Step S46 are added to the list.

In the processing of Step S28, the predetermined frequency in the reception band is set as the tuning frequency, and thus it is determined whether or not the quality of the received signal having the tuning frequency is equal to or higher than the standard. When it is determined in the processing of Step S28 that the quality of the received signal having the tuning frequency is lower than the standard, the operation proceeds to the processing of Step S31. It is noted that since the contents of the predetermined pieces of processing in and after Step S31 are the same as those in the display method according to the second embodiment of the present disclosure, a repeated description is omitted here for the sake of simplicity.

On the other hand, when it is determined in the processing of Step S28 that the quality of the received signal having the tuning frequency is equal to or higher than the standard, the operation proceeds to processing of Step S43. In the processing of Step S43, it is determined whether or not the tuning frequency becoming the object of the determination in the processing of Step S28 is present in the list which was created in the last-minute scanning processing. When it is determined in the processing of Step S43 that the tuning frequency becoming the object of the determination in the processing of Step S28 is absent in the list which was created in the last-minute scanning processing, the operation proceeds to processing of Step S44.

In the processing of Step S44, the tuning frequency becoming the object of the determination in the processing of Step S28 is added to the list. Also, the operation proceeds to the processing of Step S29. In the processing of Step S29, the name of the broadcasting station corresponding to the tuning frequency is displayed in the normal display form. It is noted that since the contents of the two pieces of processing in Step S43 and Step S44 are the same as those of the two pieces of processing in Step S41 and Step S42 described above.

When in determination processing in Step S43, the tuning frequency becoming the object of the determination in the processing of Step S28 is present in the list which has been created in the last-minute scanning processing, the operation proceeds to processing of Step S45. In the processing of Step S45, it is determined whether or not the name of the broadcasting station corresponding to the tuning frequency becoming the object of the determination is displayed in the form of the gray list. When the gray flag corresponding to the tuning frequency becoming the object of the determination is 0, the broadcasting station name is displayed in the normal display form and thus is not display in the form of the gray list. In this case, the operation proceeds to the processing of Step S29, and the display made in the normal display form is continuously carried out.

On the other hand, when the gray flag corresponding to the tuning frequency becoming the object of the determination is 1, the broadcasting station name is displayed in the form of the gray list. In this case, the operation proceeds to processing of Step S46. In the processing of Step S46, the gray flag is reset. That is to say, the gray flag is changed from 1 to 0. In addition, the timer which was counted up when the broadcasting station name was displayed in the form of the gray list is reset. Also, the operation proceeds to the processing of Step S29. The processing of Step S29, the broadcasting station name displayed in the form of the gray list is displayed in the normal display form. Also, the operation proceeds to the processing of Step S30.

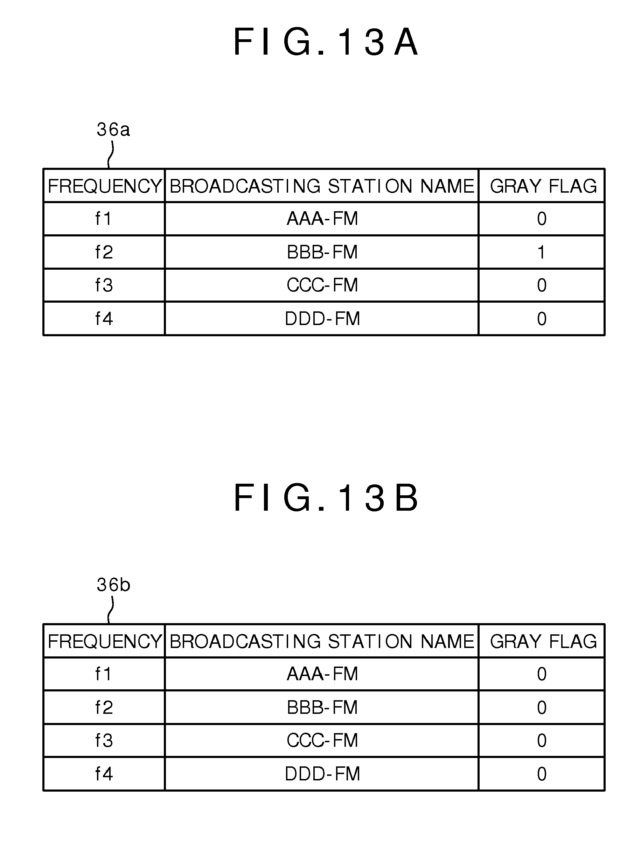

The predetermined pieces of processing in Step S44, Step S45, and the like will now be concretely described below with reference to FIGS. 13A and 13B. A list 36a exemplified in FIG. 13A is created through the last-minute scanning processing. The display based on the list 36a is carried out in the display portion 18. The broadcasting station name AAA-FM, the broadcasting station name CCC-FM, and the broadcasting station name DDD-FM are all displayed in the normal display form on the display portion 18. On the other hand, the broadcasting station name BBB-FM is displayed in the form of the gray list on the display portion 18.

In the determination processing in Step S28, for example, the frequency f2 is set as the tuning frequency. Also, it is determined that the quality of the received signal having the frequency f2 is equal to or higher than the standard, and the operation proceeds to the processing of Step S43. Since the frequency f2 is present in the list 36a, the affirmation result is obtained in the processing of Step S43. Since the gray flag corresponding to the frequency f2 is 1, the broadcasting station name BBB-FM is displayed in the form of the gray list on the display portion 18. Therefore, the affirmation result is obtained in the determination processing of Step S43, and the processing of Step S46 is executed.

In the processing of Step S46, the gray flag is reset. The gray flag corresponding to the frequency f2 in the list 36a is reset, and the list 36a is changed to the list 36b shown in FIG. 13B. Also, the processing of Step S29 is executed. In the processing of Step S29, the display based on the list 36b is carried out. That is to say, the broadcasting station name BBB-FM which has been displayed in the form of the gray list is displayed in the normal display form. In addition, the timer which was counted up with respect to the frequency f2 and the broadcasting station name BBB-FM is stopped in operation thereof, and the value of the timer is reset to 0. It is noted that when the timer is being actuated with respect to other items in the list, the counting-up of that timer is continuously carried out.

When the quality of the received signal from the broadcasting station whose name has been displayed in the form of the gray list become equal to or higher than the standard, the display form can be changed from the gray list over to the normal display form.

### 4. Modified Changes

Although the plural embodiments of the present disclosure have been described so far, the present disclosure is by no means limited to the embodiments described above, and thus various kinds of modified changes can be made.

The broadcasting station name may also be displayed in the form of the gray list by flashing the broadcasting station name concerned. For example, as shown in FIG. 14A, the broadcasting station name AAA-FM is displayed in the normal display form. On the other hand, as shown in FIG. 14B, the display and the non-display of the broadcasting station name BBB-FM may be repetitively carried out with a predetermined cycle and the broadcasting station name BBB-FM may be displayed in the flashing style.

The information corresponding to the broadcasting station name is by no means limited to the broadcasting station name. Thus, the information corresponding to the broadcasting station name may also be the frequency allocated to the broadcasting station. In addition, the information corresponding to the broadcasting station name may also be an icon or a thumbnail image. In addition thereto, a combination thereof may also be used as the information corresponding to the broadcasting station name.

The present disclosure can be applied not only to the radio broadcasting, but also a television broadcasting.

The present disclosure can be realized by, for example, utilizing a method, a program, or a recording medium having a program recorded therein in addition to an apparatus. It is noted that the configuration and the processing in the embodiments and the modified changed can be suitably changed or combined with each other within the range free from the technical contradiction. The present disclosure may also be applied to a so-called Cloud System in which the exemplified pieces of processing are dispersively processed by plural devices or apparatuses.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

The present disclosure can also adopt the following constitutions.
(1) A receiving apparatus including:
   a determining portion configured to scan a reception band of a broadcasting wave, compare a quality of a received signal with a predetermined quality, and carry out a determination; and
   a control portion configured to
      display information corresponding to a first broadcasting station in a first display form, a quality of a received signal from the first broadcasting station being determined to be equal to or higher than the predetermined quality, and
      display information corresponding to a second broadcasting station in a second display form, a quality of a received signal from the second broadcasting station being determined to be lower than the predetermined quality, the second display form being different from the first display form.
(2) The receiving apparatus described in the paragraph (1), in which the control portion displays the information corresponding to the second broadcasting station for a previously set period of time.
(3) The receiving apparatus described in the paragraph (2), in which when the previously set period of time lapses and the quality does not become equal to or higher than the predetermined quality, the control portion causes the information corresponding to the second broadcasting station to be non-display.
(4) The receiving apparatus described in the paragraph (2), in which when the quality becomes equal to or higher than the predetermined quality for the previously set period of time, the control portion changes the display form of the information corresponding to the second broadcasting station from the second display form over to the first display form, thereby displaying the information corresponding to the second broadcasting station in the first display form.
(5) The receiving apparatus described in any one of the paragraphs (1) to (4), in which the determining portion determines the quality by using at least one of a strength of an electric field, noise information, and an error rate.
(6) The receiving apparatus described in any one of the paragraphs (1) to (4), in which when the determining portion carries out the determination for a strength of an electric field of the received signal and the strength of the electric field is equal to or larger than a predetermined value, the determining portion carries out the determination by using at least one of noise information and an error rate.
(7) The receiving apparatus described in any one of the paragraphs (1) to (6), in which each of the information corresponding to the first broadcasting station and the information corresponding to the second broadcasting station is at least one of a name of a broadcasting station and a frequency allocated to the broadcasting station.
(8) The receiving apparatus described in any one of the paragraphs (1) to (7), in which the first display form and the second display form are display forms in which display colors are different from each other.
(9) The receiving apparatus described in any one of the paragraphs (1) to (7), in which the second display form is a display form in which the information corresponding to the second broadcasting station is displayed in a flashing style.
(10) The receiving apparatus described in any one of the paragraphs (1) to (9), in which at least one of the information corresponding to the first broadcasting station and the information corresponding to the second broadcasting station is displayed on a display portion; and
   the information displayed is selectable.
(11) The receiving apparatus described in the paragraph (10), in which the broadcasting station corresponding to the information selected is dialed.
(12) A display method including:
   scanning a reception band of a broadcasting wave;
   comparing a quality of a received signal received through the scanning with a predetermined quality, thereby carrying out a determination;
   displaying information corresponding to a first broadcasting station in a first display form, a quality of a received signal from the first broadcasting station being determined to be equal to or higher than the predetermined quality; and
   displaying information corresponding to a second broadcasting station in a second display form, a quality of a received signal from the second broadcasting station being determined to be lower than the predetermined quality, the second display form being different from the first display form.

The present technology contains subject matter related to that disclosed in Japanese Priority Patent Application JP 2012-058227 filed in the Japan Patent Office on March 15, 2012.

## Claims

1. A receiving apparatus, comprising:
a determining portion configured to scan a reception band of a broadcasting wave, compare a quality of a received signal with a predetermined quality, and carry out a determination; and
a control portion configured to
display information corresponding to a first broadcasting station in a first display form, a quality of a received signal from the first broadcasting station being determined to be equal to or higher than the predetermined quality, and
display information corresponding to a second broadcasting station in a second display form, a quality of a received signal from the second broadcasting station being determined to be lower than the predetermined quality, the second display form being different from the first display form.

2. The receiving apparatus according to claim 1, wherein said control portion displays the information corresponding to said second broadcasting station for a previously set period of time.

3. The receiving apparatus according to claim 2, wherein when the previously set period of time lapses and the quality does not become equal to or higher than the predetermined quality, said control portion causes the information corresponding to said second broadcasting station to be non-display.

4. The receiving apparatus according to claim 2, wherein when the quality becomes equal to or higher than the predetermined quality for the previously set period of time, said control portion changes the display form of the information corresponding to said second broadcasting station from the second display form over to the first display form, thereby displaying the information corresponding to said second broadcasting station in the first display form.

5. The receiving apparatus according to claim 1, wherein said determining portion determines the quality by using at least one of a strength of an electric field, noise information, and an error rate.

6. The receiving apparatus according to claim 1, wherein when said determining portion carries out the determination for a strength of an electric field of the received signal and the strength of the electric field is equal to or larger than a predetermined value, said determining portion carries out the determination by using at least one of noise information and an error rate.

7. The receiving apparatus according to claim 1, wherein each of the information corresponding to said first broadcasting station and the information corresponding to said second broadcasting station is at least one of a name of a broadcasting station and a frequency allocated to the broadcasting station.

8. The receiving apparatus according to claim 1, wherein the first display form and the second display form are display forms in which display colors are different from each other.

9. The receiving apparatus according to claim 1, wherein the second display form is a display form in which the information corresponding to said second broadcasting station is displayed in a flashing style.

10. The receiving apparatus according to claim 1, wherein at least one of the information corresponding to said first broadcasting station and the information corresponding to said second broadcasting station is displayed on a display portion; and
the information displayed is selectable.

11. The receiving apparatus according to claim 10, wherein the broadcasting station corresponding to the information selected is dialed.

12. A display method, comprising:
scanning a reception band of a broadcasting wave;
comparing a quality of a received signal received through the scanning with a predetermined quality, thereby carrying out a determination;
displaying information corresponding to a first broadcasting station in a first display form, a quality of a received signal from the first broadcasting station being determined to be equal to or higher than the predetermined quality; and
displaying information corresponding to a second broadcasting station in a second display form, a quality of a received signal from the second broadcasting station being determined to be lower than the predetermined quality, the second display form being different from the first display form.
